# EUROPEAN PATENT APPLICATION

(11) **EP 3 147 387 A1**
(43) Date of publication of application: **29.03.2017**
(21) Application number: 16190656.5
(22) Date of filing: 26.09.2016
(51) Int. Cl.: C25D 1/04, C25D 5/16, C25D 7/06, C25D 3/54, C25D 3/58

(54) **SURFACE-TREATED COPPER FOIL AND METHOD OF MANUFACTURING OF THE SAME**

(30) Priority: 25.09.2015 KR 20150136611
(71) Applicant: Iljin Materials Co., Ltd., Jeollabuk-do 570-998 (KR)
(72) Inventor: Beom, Won Jin, 61084 Buk-gu (KR); Choi, Eun Sil, 55062 Jeonju-si (KR); Song, Ki Deok, 16593 Suwon-si (KR)
(74) Representative: Zech, Stefan Markus

(57) **Abstract**

The present invention relates to a surface-treated copper foil and a method of manufacturing the same. The method of manufacturing a surface-treated copper foil includes a first step of preparing an electrolytic copper foil, a second step of pickling the surface of the electrolytic copper foil, a third step of forming a nodule by roughening the pickled electrolytic copper foil in a plating bath including at least one of Mo, Co, W, Mn, Cu, H₂SO₄, and Na, and a fourth step of forming a plating layer on the formed nodule.

According to the present invention, it is possible to improve adhesion strength of a copper foil by roughening an electrolytic copper foil with metal ions of Mo, Co, W, Mn, and the like.

## Description

### [Invention Title]

### SURFACE-TREATED COPPER FOIL AND METHOD OF MANUFACTURING THE SAME

### [Technical Field]

The present invention relates to a surface-treated copper foil and a method of manufacturing the same, and more particularly, to a surface-treated copper foil having low roughness and high adhesion strength by surface-treating a copper foil and a method of manufacturing the same.

### [Background Art]

In recent years, with acceleration of miniaturization and weight reduction of electric/electronic apparatuses, a printed circuit formed on a board has been fine, high-integrated, and miniaturized, and as a result, a copper foil used in a printed circuit board has required various physical properties.

A composite for a substrate used for manufacturing a flexible substrate, a multilayered substrate for high-density mounting, a high-frequency circuit board, and the like (hereinafter, these substrates are commonly referred to as circuit boards or a printed circuit boards), which are used for these electric/electronic apparatuses is constituted by a conductor (a copper foil) and an insulation substrate (including a film) supporting the conductor. The insulation substrate ensures insulation between the conductors and has strength enough to support the component.

Further, as a speed of a signal transferred to the circuit board is increased, characteristic impedance, a signal transfer speed, or the like of an insulation material configuring the circuit board is important and thus improvement of characteristics such as a dielectric constant, a dielectric loss, and the like is required. As a material for a substrate provided of the insulation material which satisfies these conditions, phenol resin materials are frequently used and as a plating through-hole, epoxy resin materials are frequently used. Further, recently, with high-speed transmission of signals, insulation materials having a low dielectric constant and a low dielectric loss have been required and materials therefor have been developed. Further, as an insulation material for a circuit board requiring heat resistance, heat-resistive epoxy resin, polyimide, and the like have been used. In addition, materials with good dimensional stability, materials with low bending or distortion, materials with small heat shrinkage, and the like have been developed.

However, among an epoxy resin, polyimide, a liquid crystal polymer, and a polyether ether ketone-based resin, particularly, the liquid crystal polymer is known as a resin with low adhesion strength (tensile strength) to the copper foil. Generally, the tensile strength between these resins and the copper foil has a large effect on surface roughness Rz of the copper foil (herein, the surface roughness Rz means Rz defined in the definition of 5.1 ten point average roughness of "definition and indication of surface roughness" in JISB 0601-1994. Considering the surface roughness of the copper foil, surface roughness Rz of a surface-treated copper foil and Rz of a surface-roughened copper foil formed by roughening the surface of the copper foil may be included.

In the related art, in order to enhance adhesion strength for a resin with low adhesion strength, a method of enhancing surface roughness Rz by increasing current flowing when roughening and increasing an adhesion amount of granular copper when roughening was performed. However, the method is suitable as the method of enhancing the adhesion strength, but is not suitable for the printed circuit board considering a high-frequency characteristic. In order to enhance adhesion strength, when the surface of the copper foil is over-treated, there is a problem in that hindrances to high-frequency signal transmission are increased to have a bad effect on the signal transmission.

### [Summary of Invention]

### [Technical Problem]

The present is directed to provide a surface-treated copper foil and a method of manufacturing the same capable of improving adhesion strength of a copper foil by roughening an electrolytic copper foil with metal ions of Mo, Co, W, Mn, and the like.

The present is also directed to provide a surface-treated copper foil and a method of manufacturing the same with a good high-frequency characteristic by roughening an electrolytic copper foil with metal ions of Mo, Co, W, Mn, and the like.

### [Technical Solution]

An aspect of the present invention provides a surface-treated copper foil in which surface roughness of the surface-treated copper foil is 2.5 to 3.0 µm, a height of the nodule attached on one surface of the copper foil is 1.0 to 3.0 µm, a distance between the nodules is 0.1 to 0.7 µm, and the number of nodules within 25 µm of an observation section is 1 to 60.

The surface roughness of the surface-treated copper foil may be 2.5 to 2.8 µm,

The surface-treated copper foil may have adhesion strength of 0.7 kgf or greater in PPG for Low Dk.

The surface-treated copper foil may have adhesion strength of 1.0 kgf or greater in PPG for Low Dk.

The roughening for forming the nodule may be performed in a plating bath constituted by 1 to 10 g/L of Mo, 1 to 10 g/L of Co, 0.1 to 0.5 g/L of W, 10 to 20 g/L of Cu, and 100 to 200 g/L of H₂SO₄.

The roughening for forming the nodule may be performed in the plating bath constituted by 1 to 10 g/L of Mo, 0.1 to 0.5 g/L of Mn, 0.1 to 0.5 g/L of W, 10 to 20 g/L of Cu, and 100 to 200 g/L of H₂SO₄.

The roughening for forming the nodule may be performed in a plating bath constituted by 1 to 10 g/L of Mo and 1 to 10 g/L of Na.

A cover plating layer for preventing detachment of the nodule may be formed on nodule particles of the roughened surface.

Another aspect of the present invention provides a method of manufacturing a surface-treated copper foil including, a first step of preparing an electrolytic copper foil, a second step of pickling the surface of the electrolytic copper foil, a third step of forming a nodule by roughening the pickled electrolytic copper foil in a plating bath including at least one of Mo, Co, W, Mn, Cu, H₂SO₄, and Na, and a fourth step of forming a plating layer on the formed nodule.

The roughening of the electrolytic copper foil may be performed in a plating bath constituted by 1 to 10 g/L of Mo, 1 to 10 g/L of Co, 0.1 to 0.5 g/L of W, 10 to 20 g/L of Cu, and 100 to 200 g/L of H₂SO₄.

The roughening of the electrolytic copper foil may be performed in a plating bath constituted by 1 to 10 g/L of Mo, 0.1 to 0.5 g/L of Mn, 0.1 to 0.5 g/L of W, 10 to 20 g/L of Cu, and 100 to 200 g/L of H₂SO₄.

The roughening of the electrolytic copper foil may be performed in a plating bath constituted by 1 to 10 g/L of Mo and 1 to 10 g/L of Na.

Yet another aspect of the present invention provides a method of manufacturing a surface-treated copper foil, including performing surface treatment of an electrolytic copper foil by pickling the surface of the electrolytic copper foil and roughening the pickled electrolytic copper foil in a plating bath including at least one of Mo, Co, W, Mn, Cu, H₂SO₄, and Na to form a nodule, in which surface roughness of the surface-treated copper foil is 2.5 to 2.8 µm, a height of the nodule attached on one surface of the copper foil is 1.0 to 3.0 µm, a distance between the nodules is 0.1 to 0.7 µm, and the number of nodules within 25 µm of an observation section is 1 to 60.

The method may further include forming a cover plating layer for preventing detachment of the nodule on the nodule.

### [Advantageous Effect]

According to the present invention, it is possible to improve adhesion strength of a copper foil by roughening an electrolytic copper foil with metal ions of Mo, Co, W, Mn, and the like.

Further, it is possible to obtain a surface-treated copper foil with a good high-frequency characteristic by roughening an electrolytic copper foil with metal ions of Mo, Co, W, Mn, and the like.

### [Description of Drawings]

FIG. 1 is a flowchart illustrating a method for manufacturing a surface-treated copper foil according to an exemplary embodiment of the present invention.
FIG. 2 is an SEM photograph illustrating a nodule formed when an electrolytic copper foil is roughened in a plating bath including Mo, Co, W, Cu, and H₂SO₄.
FIG. 3 is an SEM photograph illustrating a cross section of the surface-treated copper foil according to the present invention.
FIG. 4 is a schematic diagram illustrating an appearance in which the nodule is formed on the surface of the electrolytic copper foil of the surface-treated copper foil according to the present invention.

### [Description of Embodiment(s)]

Hereinafter, an exemplary embodiment of the present invention and other matters required for those skilled in the art to easily appreciate the present invention will be described in detail with reference to the accompanying drawings. However, since the present invention can be implemented in various different forms within the scope described in the appended claims, the exemplary embodiment to be described below is just an illustrative regardless of expression or not.

In describing the present exemplary embodiment, in the following description, a detailed explanation of known related functions or configurations may be omitted to avoid unnecessarily obscuring the subject matter of the present invention. Furthermore, it should be noted that the same elements will be designated by the same reference numerals and symbols although they are shown in different drawings. In the drawings, the thickness or size of each layer may be enlarged or different from an actual thickness or size of each layer.

Next, a surface-treated copper foil and a manufacturing condition according to an exemplary embodiment of the present invention will be described in more detail.

[Surface-treated copper foil]

The surface-treated copper foil according to the exemplary embodiment of the present invention includes a roughened surface with a nodule attached to at least one surface of the copper foil, surface roughness of the surface-treated copper foil is 2.5 to 3.0 µm, a height of the nodule attached on one surface of the copper foil is 1.0 to 3.0 µm, a distance between the nodules is 0.1 to 0.7 µm, and the number of nodules within an 25 µm of an observation section is 1 to 60. The surface roughness is more preferably 2.5 to 2.8 µm.

Meanwhile, the surface-treated copper foil has adhesion strength of 0.7 kgf or greater in PPG for Low Dk and more preferably adhesion strength of 1.0 kgf or greater.

The height of the nodule described in the present invention means a distance between the copper foil surface and the apex of the nodule, and the height of the nodule formed on the surface of the electrolytic copper foil which is roughened may be in a range of 1.0 µm to 3.0 µm. The nodule is formed on the electrolytic copper foil, and when the height of the nodule is less than 1.0 µm, it is not preferred that the height of the nodule adhering to the resin is decreased and the adhesion strength is not excellent. When the height of the nodule is greater than 3.0 µm, it is not preferred that a deviation in surface roughness of the surface of the electrolytic copper foil is increased and thus stable adhesion strength may not be maintained and a high-frequency characteristic is deteriorated.

Further, it is preferred that the distance between the nodules is in a range of 0.1 µm to 0.7 µm. When the distance between the nodules is less than 0.1 µm, it is not preferred that the distance between the nodules is decreased and thus the adhesion portion with the resin is insufficient and the adhesion strength is deteriorated. When the distance between the nodules is greater than 0.7 µm, it is not preferred that binding force between the electrolytic copper foil and the nodule is decreased and thus the nodule may not be easily detached from the surface of the copper foil and the adhesion strength is decreased.

Further, it is preferred that the number of nodules exists 10 to 60 within 25 µm of an observation section. When the number of nodules within 25 µm of an observation section is less than 10, it is not preferred that there is a problem in that the adhesion strength of the electrolytic copper foil is decreased. When the number of nodules is greater than 60, it is not preferred that the distance between the nodules is decreased and thus the adhesion portion with the resin is insufficient and the adhesion strength is deteriorated.

### [Method for manufacturing surface-treated copper foil]

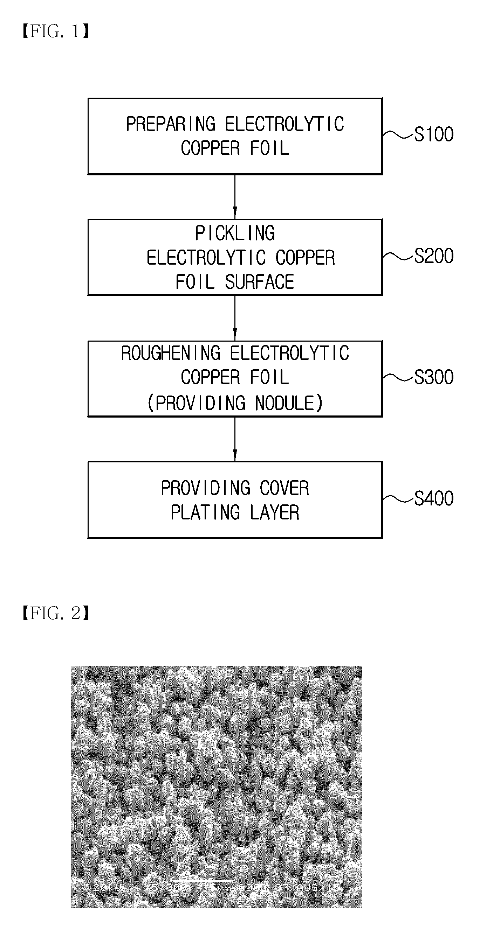

FIG. 1 is a flowchart illustrating a method for manufacturing a surface-treated copper foil according to an exemplary embodiment of the present invention.

The method for manufacturing the surface-treated copper foil according to the exemplary embodiment includes a first step of preparing an electrolytic copper foil (S100), a second step of pickling the surface of the electrolytic copper foil (S200), a third step of forming a nodule by roughening the pickled electrolytic copper foil in a plating bath including at least one of Mo, Co, W, Mn, Cu, H₂SO₄, and Na (S300), and a fourth step of forming a cover plating layer on the formed nodule (S400).

In the first step (S100), the electrolytic copper foil of 12 µm is prepared. In the first step of preparing the electrolytic copper foil (S100), in order to manufacture the electrolytic copper foil, an elecrolyzer system having a capacity of 3 L which is circulatable at 20 L/min is used. A copper electrolyte used for manufacturing the copper foil may have a composition of 250 to 400 g/L of CuSO4 5H2O, 80 to 150 g/L of H₂SO₄ and chlorine ions and additives may be added.

Further, the temperature of the copper electrolyte used for manufacturing the copper foil is uniformly maintained at 45°C. A cathode for manufacturing the copper foil uses a dimensionally stable electrode (DSE) plate having a thickness of 5 mm and a size of 10×10cm2. An anode also uses a titanium plate having a thickness of 5 mm and a size of 10×10cm2 like the cathode. Further, in order to facilitate the movement of Cu2+ ions, plating is performed with current density of 35 A/dm2 and the electrolytic copper foil is manufactured with a thickness of 12 µm.

Next, in the second step (S200), the surface of the electrolytic copper foil is pickled. The process of pickling the surface of the electrolytic copper foil in the second step (S200) is a step for cleaning the copper foil by removing impurities of the copper foil surface. In the present invention, it is preferred to clean the copper foil through pickling. The method of pickling the surface of the electrolytic copper foil is not particularly limited so long as being methods known in the art, but as a non-limited example, degreasing and polishing may be selectively used. The degreasing is to remove residuals existing in the copper foil and alkaline degreasing, acid degreasing, or electrolytic degreasing may be applied.

Thereafter, in the third step (S300), the electrolytic copper foil which is cleaned by pickling is roughened in the plating bath including at least one of Mo, Co, W, Mn, Cu, H₂SO₄, and Na to form the nodule. When the electrolytic copper foil is roughened, the metallic ions included in the plating bath are roughened for 4 seconds with the current density of 20 A/dm2 in the plating bath including at least one metallic ion of Mo, Co, W, Mn, Cu, H₂SO₄, and Na. The nodule is formed on the surface of the electrolytic copper foil roughened in the third step (S300). When the nodule is formed on the surface of the electrolytic copper foil through roughening, the surface area of the electrolytic copper foil is increased and as a result, the adhesion strength of the nodule is increased. The surface-treated copper foil according to the present invention is suitable for printed circuit boards for Low Dk and high frequency and particularly, has high adhesion strength in Low Dk prepreg. According to the present invention, the surface roughness of the electrolytic copper foil which is roughened has a range of 2.5 to 3.0 µm and has adhesion strength of 0.7 kgf or greater in Low Dk PPG.

More preferably, the surface roughness of the electrolytic copper foil which is roughened according to the present invention may have a range of 2.5 to 2.8 µm and the adhesion strength in Low Dk PPG is more preferably 1.0 kgf or greater.

The roughening for forming the nodule is performed in the plating bath including at least one metallic ion selected from Mo, Co, W, Mn, Cu, H₂SO₄, and Na. The roughening for forming the nodule may be performed in the plating bath constituted by 1 to 10 g/L of Mo, 1 to 10 g/L of Co, 0.1 to 0.5 g/L of W, 10 to 20 g/L of Cu, and 100 to 200 g/L of H₂SO₄. For reference, FIG. 2 illustrates an SEM photograph of the nodule formed when the electrolytic copper foil is roughened in a plating bath constituted by 1 to 10 g/L of Mo, 1 to 10 g/L of Co, 0.1 to 0.5 g/L of W, 10 to 20 g/L of Cu, and 100 to 200 g/L of H₂SO₄.

Further, the roughening for forming the nodule may be performed in a plating bath constituted by 1 to 10 g/L of Mo, 0.1 to 0.5 g/L of Mn, 0.1 to 0.5 g/L of W, 10 to 20 g/L of Cu, and 100 to 200 g/L of H₂SO₄.

Further, the roughening for forming the nodule may be performed in a plating bath constituted by 1 to 10 g/L of Mo and 1 to 10 g/L of Na.

Meanwhile, it is preferred that the height of the nodule formed on the surface of the electrolytic copper foil which is roughened in the third step (S300) is in a range of 1.0 µm to 3.0 µm. The height of the nodule described in the present invention means a distance between the surface of the copper foil and the apex of the nodule.

When the height of the nodule is less than 1.0 µm, it is not preferred that the height of the nodule adhering to the resin is decreased and the adhesion strength is not excellent. When the height of the nodule is greater than 3.0 µm, it is not preferred that a deviation in surface roughness of the surface of the electrolytic copper foil is increased and thus stable adhesion strength may not be maintained and a high-frequency characteristic is deteriorated.

Further, it is preferred that the distance between the nodules is in a range of 0.1 µm to 0.7 µm. When the distance between the nodules is less than 0.1 µm, it is not preferred that the distance between the nodules is decreased and thus the adhesion portion with the resin is insufficient and the adhesion strength is deteriorated. When the distance between the nodules is greater than 0.7 µm, it is not preferred that binding force between the electrolytic copper foil and the nodule is decreased and thus the nodule may not be easily detached from the surface of the copper foil and the adhesion strength is decreased.

Further, it is preferred that the number of nodules exists 10 to 60 within 25 µm of an observation section. When the number of nodules in the 25 µm of an observation section is less than 10, it is not preferred that there is a problem in that the adhesion strength of the electrolytic copper foil is decreased. When the number of nodules is greater than 60, it is not preferred that the distance between the nodules is decreased and thus the adhesion portion with the resin is insufficient and the adhesion strength is deteriorated.

Next, in the fourth step (S400), plating is performed on the nodule formed through the third step (S300) for 3 seconds at current density of 15 A/dm2 to form a cover plating layer. In the fourth step (S400), the forming of the cover plating layer on the nodule is to improve powder falling, heat resistance, and conductivity. It is preferred that the cover plating layer formed on the nodule is to form a metal plating layer of at least one metal selected from a group consisting of Ni, an Ni alloy, Zn, a Zn alloy, and Ag. However, the method of forming the plating layer on the nodule is not necessarily limited thereto and may be selectively used so long as being methods known in the art.

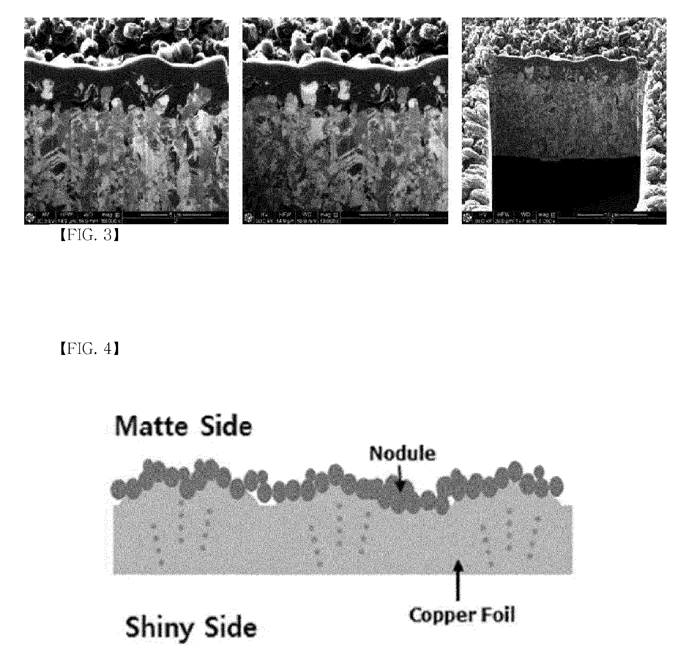

For reference, FIG. 3 is an SEM photograph illustrating a cross section of the surface-treated copper foil according to the present invention. As described above, it can be seen that in the surface-treated copper foil which is performed up to the forming of the plating layer in the fourth step (S400), the nodule is formed as illustrated in FIG. 3.

Further, FIG. 4 is a schematic diagram illustrating an appearance in which the nodule is formed on the surface of the electrolytic copper foil of the surface-treated copper foil according to the present invention. Referring to FIG. 4, it can be seen that the nodule is formed on a matte side of the electrolytic copper foil.

Hereinafter, the present invention will be described in more detail through Examples.

A test for measuring adhesion strength and surface roughness Rz of the surface-treated copper foil according to the exemplary embodiment was performed as follows.

In the method for manufacturing the surface-treated copper foil according to the present invention, pickling the surface of the electrolytic copper foil and plating the roughened surface of the nodule were performed under a generally used condition which is known in the art. Further, in Examples and Comparative Examples to be described below, adhesion strength and surface roughness Rz of the surface-treated copper foil according to the present invention were measured and compared by giving variety to configuration of metallic ions in the roughening plating bath in the method for manufacturing the surface-treated copper foil according to the present invention.

### [Examples]

Test conditions in Examples of the present invention and Comparative Examples are as follows.

### Example 1

First, Example 1 is an example in which when the electrolytic copper foil is roughened under a condition of a plating solution of Mo 2 g/L, Co 2 g/L, W 0.3 g/L, Cu 90 g/L, and H₂SO₄ 130 g/L, a nodule is formed on the surface of the electrolytic copper foil by setting current density of 20 A/dm2 and a treatment time of 4 seconds and then adhesion strength and surface roughness Rz of the electrolytic copper foil are measured.

### Example 2

Example 2 is an example in which when the electrolytic copper foil is roughened under a condition of a plating solution of Mo 3 g/L, Co 0.4 g/L, W 0.2 g/L, Cu 90 g/L, and H₂SO₄ 130 g/L, a nodule is formed on the surface of the electrolytic copper foil by setting current density of 20 A/dm2 and a treatment time of 4 seconds and then adhesion strength and surface roughness Rz of the electrolytic copper foil are measured.

### Example 3

Example 3 is an example in which when the electrolytic copper foil is roughened under a condition of a plating solution of Mo 5 g/L and Na 0.4 g/L, a nodule is formed on the surface of the electrolytic copper foil by setting current density of 20 A/dm2 and a treatment time of 4 seconds and then adhesion strength and surface roughness Rz of the electrolytic copper foil are measured.

### Comparative Example 1

Comparative Example 1 is an example in which when the electrolytic copper foil is roughened under a condition of a plating solution of Mo 2 g/L, W 0.3 g/L, Cu 90 g/L, and H₂SO₄ 130 g/L, a nodule is formed on the surface of the electrolytic copper foil by setting current density of 20 A/dm2 and a treatment time of 4 seconds and then adhesion strength and surface roughness Rz of the electrolytic copper foil are measured.

### Comparative Example 2

Comparative Example 2 is an example in which when the electrolytic copper foil is roughened under a condition of a plating solution of Mo 2 g/L, W 0.3 g/L, Cu 90 g/L, and H₂SO₄ 130 g/L, a nodule is formed on the surface of the electrolytic copper foil by setting current density of 20 A/dm2 and a treatment time of 4 seconds and then adhesion strength and surface roughness Rz of the electrolytic copper foil are measured.

Table 1 below is a table illustrated by measuring adhesion strength (kgf) and surface roughness (Rz) of the electrolytic copper foil which is surface-treated under conditions of Examples 1 to 2, Comparative Example 1 and Comparative Example 2. The surface roughness Rz was measured according to a JISB 0601-1994 standard. The surface roughness Rz means that as the value is decreased, unevenness is smaller. The adhesion strength was measured by attaching a specimen prepared in halogen-free prepreg for Low Dk with a size of 10×100 mm, preparing a specimen for measuring adhesion strength by performing a hot pressing process for 30 minutes at 210°C, and setting the prepared measuring specimen at a velocity of 50 mm per minute in U.T.M. equipment.

**[Table 1]**

| Classification | Surface Roughness (Rz) | Adhesion Strength (kgf) |
|---|---|---|
| Example 1 | 2.6 | 1.08 |
| Example 2 | 2.91 | 0.89 |
| Example 3 | 2.52 | 0.71 |
| Comparative Example 1 | 3.12 | 0.9 |
| Comparative Example 2 | 4.0 | 1.09 |

Referring to Table 1, in the case of Example 1 in which the surface-treated copper foil is manufactured by constituting the roughened plating solution to Mo, Co, W, Cu, and H₂SO₄, the surface roughness Rz and the adhesion strength of the electrolytic copper foil after roughening were measured as 2.6 µm and 1.08 kgf, respectively, and thus it is shown that the surface roughness Rz and the adhesion strength are most excellent. This means that like Example 1, when the nodule is formed by roughening the electrolytic copper foil with the plating solution including Mo, Co, W, Cu, and H₂SO₄, a surface-treated copper foil with low roughness and improved adhesion strength can be manufactured.

On the other hand, in the case of Comparative Example 1 in which the surface-treated copper foil is manufactured by constituting the roughened plating solution to the rest of Mo, W, Cu, and H₂SO₄ except for Co, the surface roughness Rz and the adhesion strength of the electrolytic copper foil after roughening were measured as 3.12 µm and 0.9 kgf, respectively, and thus it is shown that the adhesion strength is good, but the surface roughness Rz is not good.

Further, in the case of Comparative Example 2 in which the surface-treated copper foil is manufactured by constituting the roughened plating solution to the rest of Co, W, Cu, and H₂SO₄ except for Mo, the surface roughness Rz and the adhesion strength of the electrolytic copper foil after roughening were measured as 4.0 µm and 1.09 kgf, respectively, and thus it is shown that the adhesion strength is good, but the surface roughness Rz is not good.

In the case of Example 2 in which the surface-treated copper foil is manufactured by constituting the roughened plating solution to Mo, Mn, W, Cu, and H₂SO₄, the surface roughness Rz and the adhesion strength of the electrolytic copper foil after roughening were measured as 2.91 µm and 0.89 kgf, respectively, and thus it is shown that both the surface roughness Rz and the adhesion strength are good. This means that like Example 2, when the nodule is formed by roughening the electrolytic copper foil with the plating solution including Mo, Mn, W, Cu, and H₂SO₄, a surface-treated copper foil with low roughness and improved adhesion strength can be manufactured.

In the case of Example 3 in which the surface-treated copper foil is manufactured by constituting the roughened plating solution to Mo and Na, the surface roughness Rz and the adhesion strength of the electrolytic copper foil after roughening were measured as 2.52 µm and 0.71 kgf, respectively, and thus it is shown that both the surface roughness Rz and the adhesion strength are good. This means that like Example 3, when the nodule is formed by roughening the electrolytic copper foil with the plating solution including Mo and Na, a surface-treated copper foil with low roughness and improved adhesion strength can be manufactured.

The technical spirit of the present invention have been described according to the exemplary embodiment in detail, but the exemplary embodiment has described herein for purposes of illustration and does not limit the present invention. Further, it can be appreciated to those skilled in the art that various modifications of the present invention can be made without departing from the scope of the present invention.

The scope of the right for the invention is determined in the claims to be described below, and as a result, the scope of the right is not limited to the disclosure of the main body of the specification and both modification and change included in equivalent ranges to the claims will be included in the scope of the present invention.

## Claims

1. A surface-treated copper foil including a roughened surface of which a nodule is attached to at least one surface of a copper foil, wherein:
surface roughness of the surface-treated copper foil is 2.5 to 3.0 µm,
a height of the nodule attached on one surface of the copper foil is 1.0 to 3.0 µm, a distance between the nodules is 0.1 to 0.7 µm, and the number of nodules within 25 µm of an observation section is 1 to 60.

2. The surface-treated copper foil of claim 1, wherein the surface roughness is 2.5 to 2.8 µm.

3. The surface-treated copper foil of claim 1, wherein the surface-treated copper foil has adhesion strength of 0.7 kgf or greater in PPG for Low Dk.

4. The surface-treated copper foil of claim 3, wherein the surface-treated copper foil has adhesion strength of 1.0 kgf or greater in PPG for Low Dk.

5. The surface-treated copper foil of claim 1, wherein the roughening for forming the nodule is performed in a plating bath constituted by 1 to 10 g/L of Mo, 1 to 10 g/L of Co, 0.1 to 0.5 g/L of W, 10 to 20 g/L of Cu, and 100 to 200 g/L of H₂SO₄.

6. The surface-treated copper foil of claim 1, wherein the roughening for forming the nodule is performed in a plating bath constituted by 1 to 10 g/L of Mo, 0.1 to 0.5 g/L of Mn, 0.1 to 0.5 g/L of W, 10 to 20 g/L of Cu, and 100 to 200 g/L of H₂SO₄.

7. The surface-treated copper foil of claim 1, wherein the roughening for forming the nodule is performed in a plating bath constituted by 1 to 10 g/L of Mo and 1 to 10 g/L of Na.

8. The surface-treated copper foil of claim 1, wherein a cover plating layer is formed on nodule particles of the roughened surface.

9. A method of manufacturing a surface-treated copper foil, comprising:
a first step of preparing an electrolytic copper foil;
a second step of pickling the surface of the electrolytic copper foil;
a third step of forming a nodule by roughening the pickled electrolytic copper foil in a plating bath including at least one of Mo, Co, W, Mn, Cu, H₂SO₄, and Na; and
a fourth step of forming a plating layer on the formed nodule.

10. The method of claim 9, wherein the roughening of the electrolytic copper foil is performed in a plating bath constituted by 1 to 10 g/L of Mo, 1 to 10 g/L of Co, 0.1 to 0.5 g/L of W, 10 to 20 g/L of Cu, and 100 to 200 g/L of H₂SO₄.

11. The method of claim 9, wherein the roughening of the electrolytic copper foil is performed in a plating bath constituted by 1 to 10 g/L of Mo, 0.1 to 0.5 g/L of Mn, 0.1 to 0.5 g/L of W, 10 to 20 g/L of Cu, and 100 to 200 g/L of H₂SO₄.

12. The method of claim 9, wherein the roughening of the electrolytic copper foil is performed in a plating bath constituted by 1 to 10 g/L of Mo and 1 to 10 g/L of Na.

13. A method of manufacturing a surface-treated copper foil, comprising performing surface treatment of an electrolytic copper foil by pickling the surface of the electrolytic copper foil and roughening the pickled electrolytic copper foil in a plating bath including at least one of Mo, Co, W, Mn, Cu, H₂SO₄, and Na to form a nodule,
wherein surface roughness of the surface-treated copper foil is 2.5 to 2.8 µm, a height of the nodule attached on one surface of the copper foil is 1.0 to 3.0 µm, a distance between the nodules is 0.1 to 0.7 µm, and the number of nodules within 25 µm of an observation section is 1 to 60.

14. The method of claim 13, further comprising: forming a cover plating layer on the nodule.
